Europäisches Patentamt

(19) European Patent Office

Office européen des brevets

(11) Publication number: **0 197 276**
A2

(12) **EUROPEAN PATENT APPLICATION**

(21) Application number: **86102413.1**

(22) Date of filing: **25.02.86**

(51) Int. Cl.⁴: **H 05 K 3/10**
**H 05 K 3/00**

(30) Priority: **09.04.85 IT 2028485**

(43) Date of publication of application:
**15.10.86 Bulletin 86/42**

(84) Designated Contracting States:
**AT BE CH DE FR GB LI NL SE**

(71) Applicant: **TELETTRA Telefonia Elettronica e Radio S.p.A.**
**Corso Buenos Aires 77/A**
**Milano(IT)**

(72) Inventor: **Marengo, Giuseppe**
**Piazza S. Agostino 18**
**Milan(IT)**

(74) Representative: **Incollingo, Italo**
**Telettra S.p.A Patent Department Via Trento no. 30**
**I-20059 Vimercate (Milano)(IT)**

(54) **Process to manufacture printed circuit boards (PCB'S) and related new products.**

㊼ The manufacturing process of printed circuit boards (pcb's), generally consisting of a support which on a major face or side carries circuit components according to the requested design and on its second major face or side carries the soldered wires corresponding to said circuit components, is now based on the fact that the designs of the component side, respectively of the soldering side are each transformed into labile electrostatic images on which good conductive metallic poweder (toner) is applied. The so obtained tracks are printed on insulating sheets (one printed with tracks reproducing the component side design, and an other with the tracks reproducing the solder side) and said printed sheets are fixed on the pcs rigid and thick support which is thereafter treated to enlarge adequately the conductive tracks.

./...

Fig. 5

The present invention refers to a manufaturing process of printed circuit boards (pcb's) generally consisting of a support which on its first face or side mounts the circuit components arranged as per the requested drawing and on its second face or side the soldered wires corresponding to said circuit components.

This invention also concerns the printed circuit boards obtained with the present process as well as the new printed circuit boards characterized by a rigid support with a thickness exceeding e.g. 5mm and (fixed to the two faces of the latter) by a first sheet carrying the printed tracks with conductive material according to the geometry of the circuit components and by a second sheet carrying the geometry of the soldering side.

Description of the Prior Art

It is generally known that the pcb's are not only used in electronics, but also in circuits for a lot of other electrical equipment.

The development of said equipment is very fast and obstacles are found only in the manufacturing processes of said pcb's.

In fact, the wide spread conventional process is long and expensive. It involves a great deal of waste of material (also precious material).

Besides it leads to considerable ecological problems to eliminate the fall-out material.

The conventional manufacturing process adopted by almost all pcb manufacturers involves, in its initial portion, at least the following steps:

1) application of the CAD processor output to a photographic plotter, which has the disadvantage of having to operate in a dark room;

2) preparation of a set of films (at least three films i.e. two for the two faces and one for the solder resist); if six layers are required, six films are necessary plus the solder resist film mask, said films correponding to the photographic negatives;

3) use of equipment of silk screens racks;

4) coating of the photographic emulsion;

5) contact printing in which the films produced in phase 2) are placed one at a time and illuminated to obtain a positive;

6) development;

7) completion of the silk screen (i.e. the circuit layout);

7') obtenainment of the finished silk screen with solder resist;

8) operations as finishing, drilling and blocking-out etc.

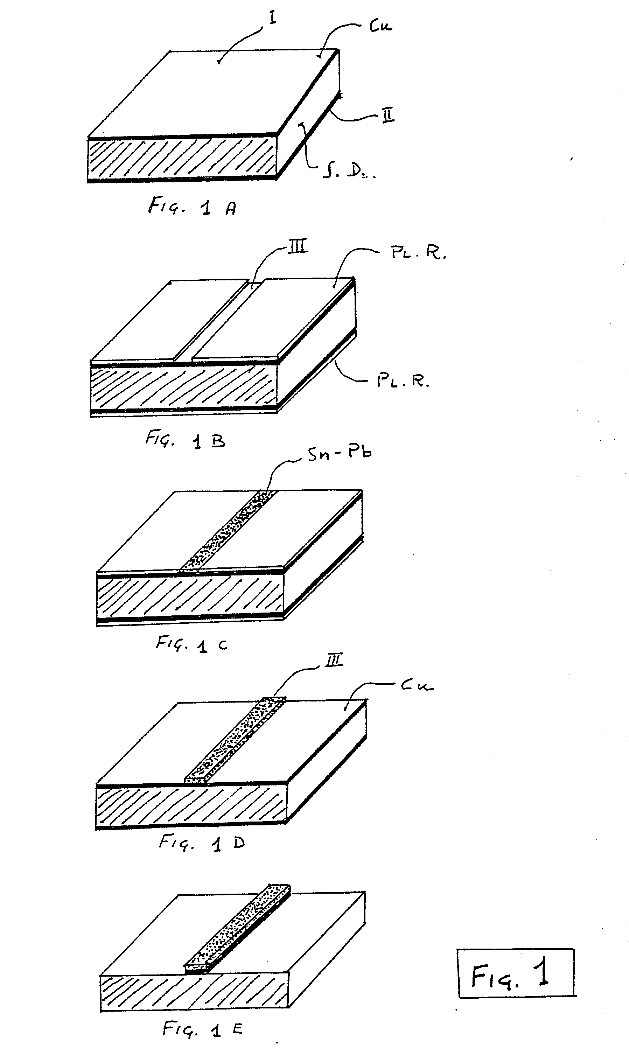

Figure 1 gives a simplified example of the conventional process philosophy by showing the shapes that the pcb assumes during preparation; figure 1A shows how a layer of copper Cu is applied to each major face I and II of a dielectric thick and rigid support SD; figure 1B illustrates che covering with which a layer of plating resist (PL.R) is applied to uncovered sections I and II, whereas area III is not covered by PL.R; in figure 1C a layer of tin-lead (Sn-Pb) is applied to III; in figure 1D all the masking plating-resist (PL.R) is taken away whereby the Cu layer covered by Sn-Pn is uncovered only in zone III; and in figure 1E the chemical etching is carried out which removes the whole initial layer of copper as well as the one in zone III protected by the Sn-Pb layer that does not resist to the chemical attack.

Moreover to produce drilled boards, drilling operation has to be made immediately after the operation of figure 1A. However, to internally metallize the holes, layers of chemical copper are firstly applied and are followed by layers of galvanic copper on both faces I and II. Afterwards, the procedure shown in figure 1B is followed, i.e. covering, application of Sn-Pb, removal of the plating resist and the chemical etching.

As already pointed out, the conventional processes are not only time consunming but they are also expensive as regards waste material. This gives rise to pollution trouble when eliminating same waste material.

In particular, the conventional process does not only involve a lot of operations like said preparation of negatives (2), silk screen racks (3), layout of photographic emulsion, printing (5) and development (6), but it is also redundant in that these operations are going to be repeated at least as many time as are the quantities of layers (besides prepararing the solder resist). From figures 1A and 1B it results that in order to cover only section III it is necessary to cover in the initial phase all major faces of rigid support SD first with copper and then with plating resist. Almost 90% of said material is removed and essentially wasted thus giving rise to considerable trouble of ecological elimination.

SUMMARY OF THE INVENTION

The main object of this invention is now a process which does not show the disadvantages of the conventional procedures, involves less and simpler operations and moreover avoids the waste of precious material.

Another object is to provide printed circuit boards with a different structure than the conventional one, i.e. simpler, more economical and more efficient.

The above scopes are reached with the process of the invention which comprises:

A)   transforming the designs of the "component side" or face and of the solder side into labile electrostatic images on a drum, on which images conductive material (f.i.a toner) is deposited and fixed;

B)   printing the tracks of said conductive material on flexible insulating sheets;

C)   firmly apply the so printed sheets on the two major faces of a thick and rigid support;

D)   treating said rigid support carrying the insulating sheets glued on its two major faces, to enlarge (grow) the section of the tracks printed on the sheets and to adapt the electrical circuit section to the previewed current; and

E)   performing the conventional or other mechanical workings to give to the pcb its final shape and to drill the holes.

Other major features of the process according to the invention are recited in the sub-claims from 2 to 6.

The invention also comprises new printed circuit boards consisting of a thick and rigid support which carries on its major faces, sheets printed with tracks, said tracks being enlarged according to the component side geometry and the soldering side geometry.

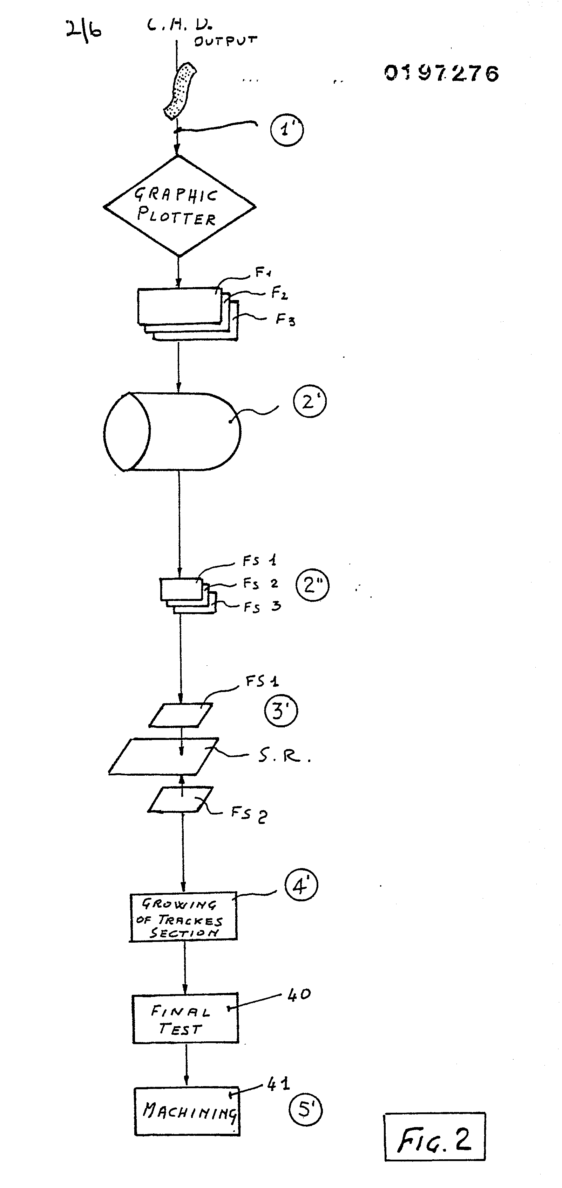

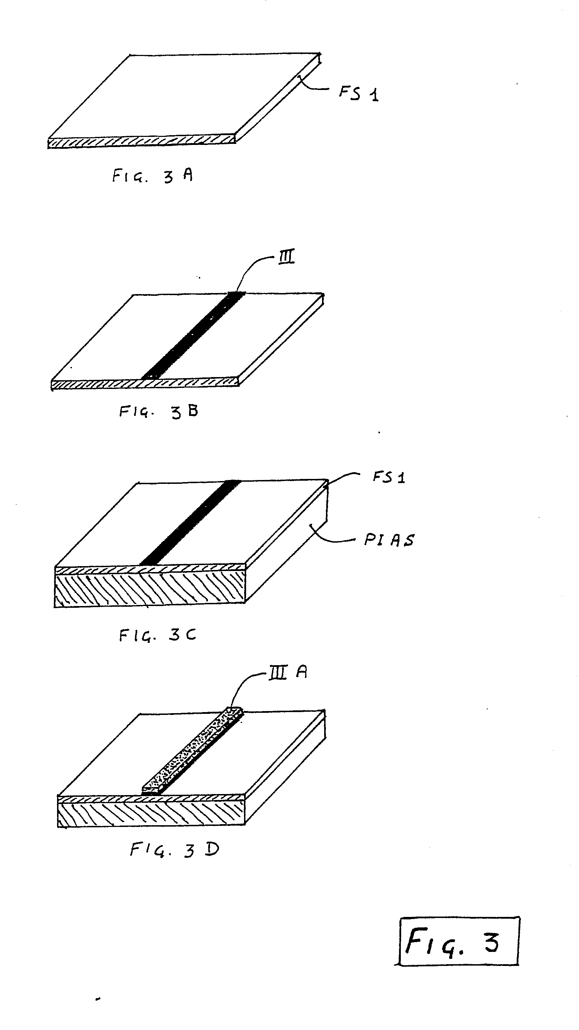

The various aspects and advantages of the invention will become clear from the following descriptin of the realisation forms, represented in the attached drawings, figures 2 to 6 of which are process schemes of the invention, while figure 3 is a view of the new pcb similar to figure 1.

The embodiment of fig. 2, even if rather complex and thus not preferred, is given to show the process in its most general form and thus to make it easy to understand.

In block 1' the CAD output is applied to a non photographic plotter (e.g. a graphical plotter (PG). With this plotter it is possible to reproduce, e.g. on three separate sheets F1, F2 and F3, the designs of the "component side", "soldering side" and of the "solder resist", respectively said sheets F1, F2 and F3 (three for the sake of simplicity in figure 2, but they may also be 1,2 ...n) are constituted of moisture and heat proof films which are preferably flexible and have a thickness of from 5 to 200 microns; they receive e.g. ink. Said sheets F1, F2 ... Fn are preferably of polyethelene-terephthalate, e.g. Mylar (trade mark of Du Pont).

Each one is drawn with ink, e.g. F1 with the component side design, F2 with the soldering side design and F3 with the solder resist design. Said designs may have a graduated scale greater than 1:1 in order to reduce errors during printing.

Printing (performed in 2') consists in applying and fixing the conducting material (e.g. copper powder) according to the sections drawn on sheets F1, F2 and F3.

So, printed sheets FS1, FS2 and FS3 go out from 2" with the printed circuit layout and solder resist mask impressed on it.

In 3' the printed track sheets are firmly applied (e.g. with glue) to the two faces of a rigid dielectric material, thereby pointing the plates to be drilled.

In 4' a treatment is performed to enlarge the sections of the tracks (previously printed) with conducting material.

Said treatment may be done with chemical means (e.g. by applying chemical copper) and/or mechanical means (e.g. overmel- ting or with other knowingly suitable means).

In 5 a quality final text is carried out and in 5' mechanical processes take place to obtain the definite shape (blocking-out) of the finished board in case of surface mounting of pcb's without holes. If the printed circuit boards outgoing from 4' are provided with metallized holes they will undergo the conventional treatment of the traditional boards as drilling, pickling, sensitization, covering, chemical copper catalysis, galvanic copper flash, surface activation, galvanic copper, activation, Sn-Pb alloy deposit, solder resist printing, solder resist boiling, final check, mechanical process.

Summarizing, the printed circuit boards according to the invention consist now of a rigid support S.R. e.g. an actual board of synthetic material having a thickness from 0.5 to 20 mm,and two flexible sheets, one of them (FS1) carrying the circuit tracks, the other one (FS2) the geometry of the soldering side, said sheets being obtained from non photographic plottered sheets, F1, F2 and F3, reproduced and printed according to the designed sections with conducting material on flexible supports, then fixed to the support (S.R.) major faces to be successively submitted to enlargement (4') of the conductors and to conventional treatments (5, 5' etc.)

Figure 3 (similar to figure 1) shows the outstanding phases of the process in a view of the boards being manufactured.

Figure 3A illustrates one of the flexible sheets FS1 e.g. of 50 micron Mylar. Figure 3B illustrates track III first designed with a graphic plotter and then printed with conducting material on FS1.

Figure 4C shows FS1 applied to the board PIAS.

Figure 4D shows track III applied to FS1 enlarged with a second layer of copper or other conducting material III.A.

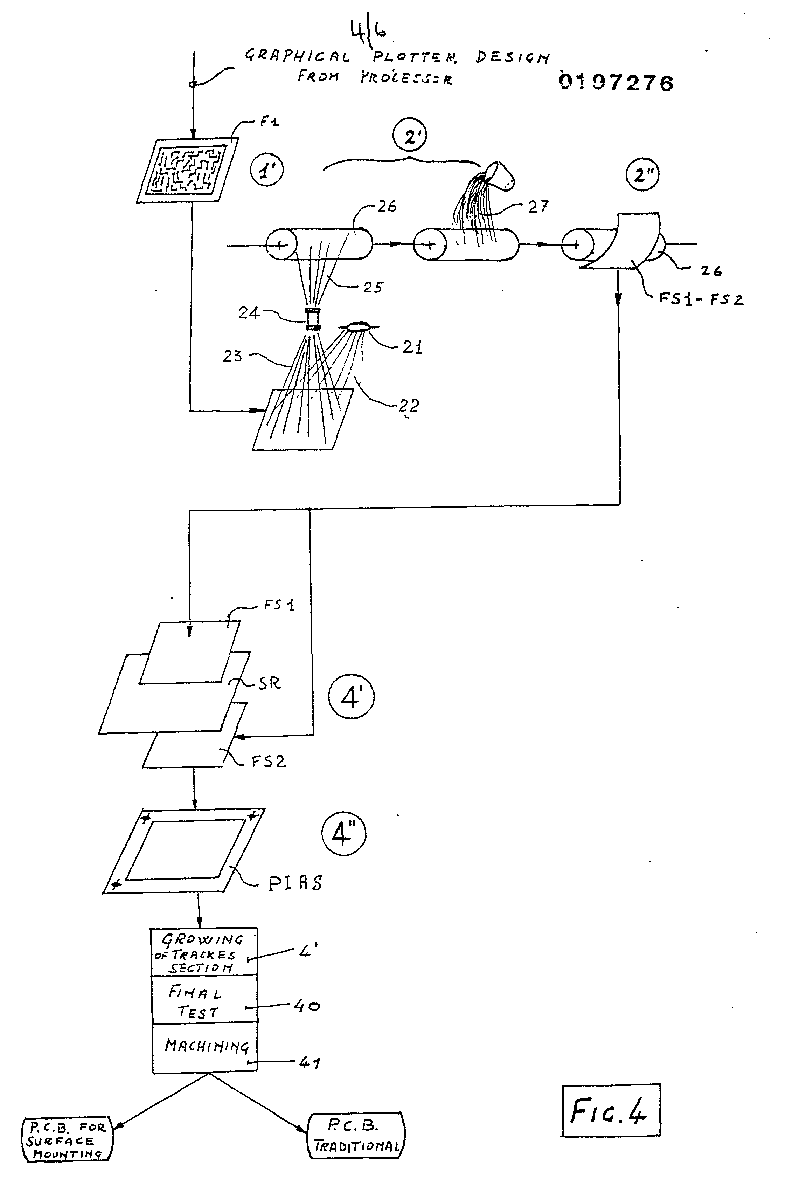

Figure 4 shows an embodiment of the invention, wherein 1' still represents one of the films, e.g. F1 on which the circuit tracks are designed f.i. graphically plotted. F1 preferably is a china ink master in a graduated scale from 1:1 to 4:1. In 2' a simple system for applying conducting material (e.g. ink to copper) to said ink traces is shown: the plotted upper surface of F1 is illuminated by a light source 21 (e.g. a flash) the rays of which 22 are reflected (as rays 23) to a system of lens 24, the output rays of which 25 are directed towards a drum (e.g. selenium) 26. In this way, on the drum a labile image of the ink plotted trace is formed. A metallic powder 27 is applied to the lines of said image. Said metallic powder must be colloidal state containing Cu, Ag, Zn and Au and able to attack only in the opposite electrostatic charge regions, i.g. exactly on the outlines of the image. The photostatic application is similar to the application of toner in a photostatic copying machine.

In 2" the selenium drum 26 prints and fixes the metallic tracks on sheet FS1. Printing and fixing are repeated for sheet FS2 that carries the geometry of the soldering side.

In 4' FS1 and FS2 are glued to the two major faces of a rigid support SR being much more thicker than sheets FS1 and FS2, e.g. by 0.5 to 20 mm.

Essentially SR is a support obtained by compressing or injecting synthetic material, e.g. one or more (co) polymers of olefines, vinyl compounds, esters, amids, dichloroethylenes etc. Said materials have the advantage of being dielectric, stable etc. and may be treated on the surface to increase their adhesion to the printed sheets and to the section of tracks. However, it is pointed out that the rigid support SR can also be metallic or partially metallic.

In fact, upon increasing the degree of integration, hence the concentration of electronic components, much more heat is produced (per surface unit of SR) and must be dispersed. Therefore, if SR is made of synthetic material, it shall be coupled to a board (e.g. in Al) with a high leakage of heat.

The process of the invention in which the circuit and soldering tracks are not directly applied to the rigid supporto SR, but instead to thin flexible supports FS1, FS2 has the further advantage of adopting rigid supports SR with such dimensions, compositions and structures that high heat leakages can be achieved.

Board PIAS goes out from 4' and is drilled with squared reference holes from CAM.

The boards outgoing from 4" are treated in 4' to enlarge the section of conductors and upon having been tested in 40 they can be sent to the other working operations which will be exclusively mechanical in the event of boards for suface mounting without holes (41) or other mechanical, drilling or electrochemical processes if traditional pcb's with metallic holes are involved (42).

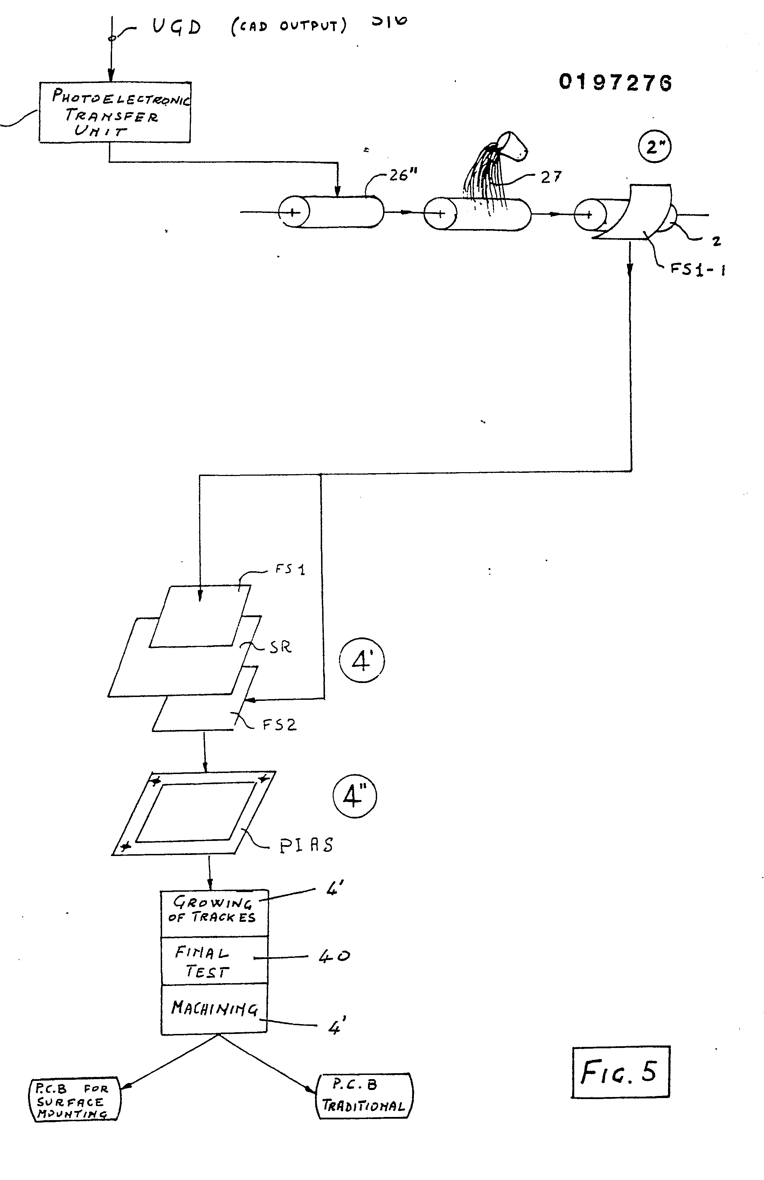

Fig. 5 shows the preferred and most advantageous embodiment of the invention. In this case the first three steps of the process of Fig. 2 i.e. the use of the CAD signal, its application to a graphic plotter, and the preparation of the ink plotted sheets F1, F2 and F3 are eliminated by utilizing directly a digitalized graphic output UGD from a computer (not shown) and by applying this digital signal to a electrophotographic transfert unit UTEF (1") which transfers said graphic output directly to the photoconductor drum 26" (corresponding to drum 26 of fig. 4) whereby this last is able to receive the toner 27 and to give in step 2" the sheets FS1 and FS2. These sheets are then submitted to the same further operations of fig. 4 i.e. are fixed to a support SR (step 4') giving thus a board PIAS formed of the support SR bearing the said printed sheets FS1 and FS2 which undergo the treatment 4' (growing of the tracks), the final quality text 40, the convention workings 41 and the selection  toward 41' pcb for surface mountings) and 42 (conventional pcb).

It can be appreciated that the utilization of the graphic digitalized output UGD and its direct application to the drum 26" as in the process of fig. 5 eliminate now the design from the graphic plotter GPD, the relevant master F1 and the optical transfer system 21-22-23-24 and 25 of figure 4.

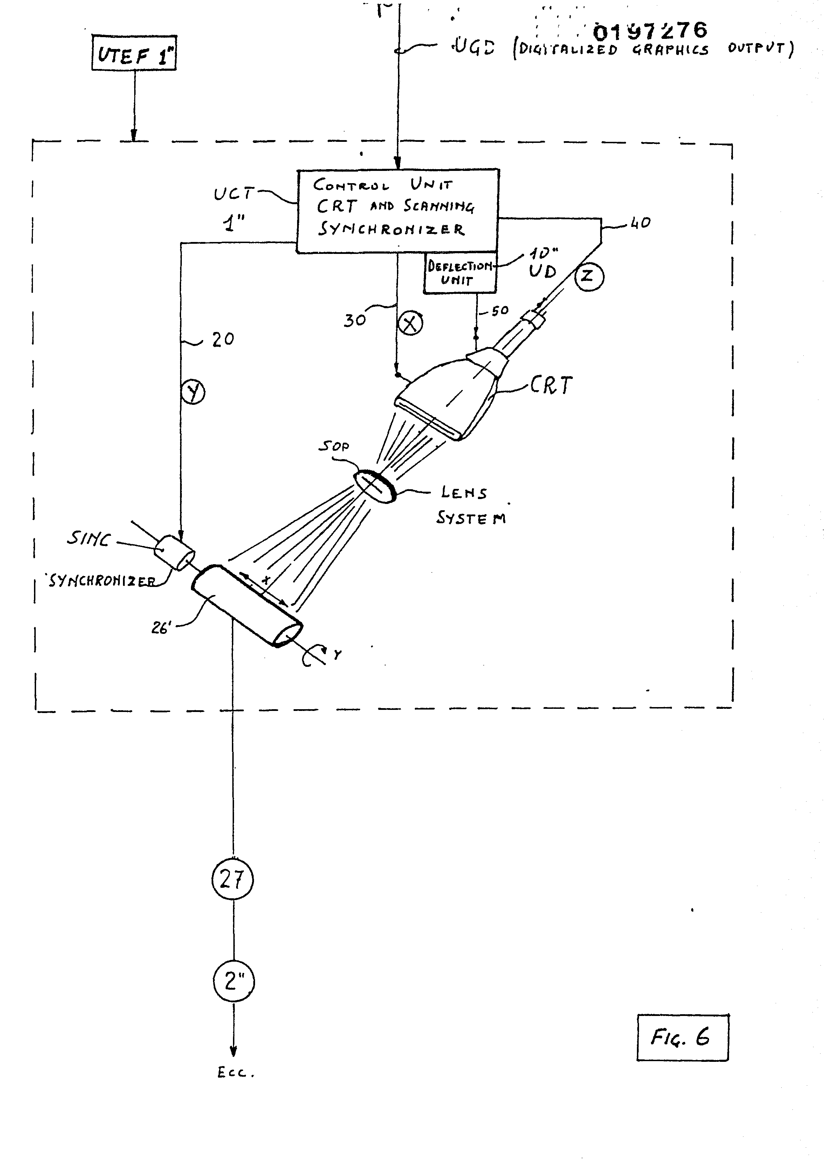

Fig. 6 shows the scheme of a preferred embodiment of the transfer unit UTEF (1") of fig. 5: it comprises a control unit UCT of a cathode tube TCR (CRT) and of a scanning synchronization, 1" which delivers the signals to command the positioning on axis y (through line 20 and synchronizer SINC) of drum 26', and of the axis x (line 30) and z (line 40) of same drum by acting however on the rays outgoing from tube TRC (CRT) which throughan optical projection system SOP creates the labile image on drum 26'.

UCT comprises also a deflection unit 10" acting on TRC (CRT) throughline 50. As in figures 4 and 5 the drum 26' undergoes operation 27 (toner application) and 2" (transfer of the toner tracks from 26 to print the sheets FS1 - FS2).

As is apparent from the foregoing specification the method and products of the present invention are .susceptible of being embodied with various alterations and modifications which fall within the scope of the invention, whereby specification and drawings are intented as illustrative and not restrictive.

C L A I M S

1) A process for manufacturing printed circuits boards

## C L A I M S

1) A process for manufacturing printed circuits boards (pcb's) generally consisting of a rigid support (SR) carrying, on a first major face or side, the circuit components distributed according to a requested design or geometry, and, on its second major face or side, the soldered wires corresponding to said circuit components, characterized in that the initial designs of said circuit component face respectively of said soldering side to be transferred on the rigid support major faces are transformed in labile electrostatic images, an electrically conductive powder is applied on the tracks of said images, the so distributed conductive material is transfered by printing on insulating sheets, one of these sheets printed with the component design and one of same sheets printed with the soldering design are firmly applied each on a major face of the rigid support; this printed sheets carrying support is treated to enlarge by growing the tracks of the conductive material and to submit the supports provvided with printed sheets with enlarged tracks to the mechanical working operations usually practiced with conventional boards to give them their final shape and to obtain the desired types of printed circuit boards.

2) A process according to claim 1, characterized in that the labile electrostatic images are produced on a photo-conductive drum.

3) A process according to claim 2, characterized in that said images are provided with colloidal conductive material powder similarly to what obtained with toner in a photostatic copying machine.

4) A process according to calim 3, characterized in that said images are obtained by applying the CAD output to a graphic plotter which reproduces under the form of china ink masters the circuit component design, respectively the soldering design and possibly the solder resist design each on a separate sheet (F1, F2, F3), the ink plotted traces of the china masters being optically transfered, preferably by illumination with the light of an outer-source and reflection of the rays thereof, on a selenium drum.

5) A process according to claim 3, characterized in that the labile electrostatic image is obtained by utilizing a graphic digitalized output (UGD) from a computer which is applied though an electro-photographic transfer unit (UTEF) directly on photo-conductive drum (26')

6) A process according to claim 5, characterized in that the electro-photographic transfer unit comprises a cathode ray linear tube, a unit to control said tube and to synchronize the scanning thereof, a drum synchronizer and an optical projector between the ray emitter screen of the tube and the photo-conductive drum.

7) A process substantially as described and shown.

8) Printed circuit boards as obtained by the process according to the above claims.

9) Printed circuit boards consisting of a thick rigid support (SR) having two major faces on one of which a flexible sheet printed with the electrically conductive enlarged tracks of the circuit component design is fixed and on the other major face of which a flexible sheet printed with the electrically conductive enlarged tracks of the soldering design is formly applied.

10) Printed circuit and relevant cover plates (masters) substantially as described and shown.

Fig. 1 A

Fig. 1 B

Fig. 1 C

Fig. 1 D

Fig. 1 E

Fig. 1

C.H.D.
OUTPUT

① 1'

GRAPHIC
PLOTTER

F₁
F₂
F₃

② 2'

Fs 1
Fs 2
Fs 3

② 2"

FS 1

③ 3'

S.R.

FS 2

GROWING
OF TRACKES
SECTION

④ 4'

FINAL
TEST

40

MACHINING

41

⑤ 5'

FIG. 2

FIG. 3 A

FIG. 3 B

FIG. 3 C

FIG. 3 D

FIG. 3

GRAPHICAL PLOTTER DESIGN
FROM PROCESSOR

0197276

F1

1'

2'

2"

26

27

25

24

21

23

22

FS1-FS2

FS1

SR

4'

FS2

PIAS

4"

GROWING OF TRACKES SECTION — 4'

FINAL TEST — 40

MACHINING — 41

P.C.B. FOR SURFACE MOUNTING

P.C.B. TRADITIONAL

FIG.4

UGD (CAD OUTPUT) 310

0197276

Photoelectronic Transfer Unit

26"

27

2"

FS1-1

2

FS1

SR

4'

FS2

4"

PIAS

Growing of Tracks — 4'

Final Test — 40

Machining — 4'

P.C.B for Surface Mounting

P.C.B Traditional

Fig. 5

UTEF 1"

UGD (DIGITALIZED GRAPHICS OUTPUT)

CONTROL UNIT
CRT AND SCANNING
SYNCHRONIZER

UCT 1"

DEFLECTION UNIT

10" UD

40

30 $\otimes$

50

Z

20

Y

CRT

SOP

LENS SYSTEM

SINC

SYNCHRONIZER

X

26'

Y

27

2"

Ecc.

Fig. 6